# FASCICULE DE BREVET EUROPEEN

(11) **EP 3 024 959 B1**
(45) Date de publication et mention de la délivrance du brevet: **08.09.2021**
(21) Numéro de dépôt: 14748242.6
(22) Date de dépôt: 07.07.2014
(51) Int. Cl.: C23C 14/02, C23C 14/06, C23C 14/32, C23C 16/02, C23C 16/26

(54) **PIÈCE MÉCANIQUE REVÊTUE D'UNE COUCHE DE CARBONE AMORPHE EN VUE DE SON GLISSEMENT VIS-À-VIS D'UN AUTRE COMPOSANT MOINS DUR**
MECHANISCHES TEIL MIT EINER BESCHICHTUNG AUS AMORPHEM KOHLENSTOFF ZUM GLEITEN GEGENÜBER EINER WENIGER HARTEN KOMPONENTE
MECHANICAL PART COATED WITH A LAYER OF AMORPHOUS CARBON FOR SLIDING IN RELATION TO A LESS HARD COMPONENT

(30) Priorité: 25.07.2013 FR 1357359
(43) Date de publication de la demande: 01.06.2016
(73) Titulaire: HYDROMECANIQUE ET FROTTEMENT, 42160 Andrézieux-Bouthéon (FR)
(72) Inventeur: HEAU, Christophe, 42650 SAINT-JEAN-BONNEFONDS (FR)
(74) Mandataire: Santarelli
(86) Numéro de dépôt international: PCT/FR2014/051747
(87) Numéro de publication internationale: WO 2015/011361

(56) Documents cités:
- EP-A2- 1 479 946
- WO-A1-2008/149707
- WO-A1-2012/073717
- WO-A1-2015/009725
- DE-A1-102011 076 410
- JP-A- 2005 003 094

## Description

L'invention concerne le traitement de composants mécaniques destinés à glisser sous forte charge par rapport à des composants en matériaux plus mous. Elle vise notamment, mais pas exclusivement, le traitement d'axes de piston, au sein de moteurs à combustion, puisque ces composants reçoivent un revêtement dur en carbone amorphe (on rencontre parfois l'appellation « de type DLC » (on parle aussi de « carbone-diamant ») ; ces notions sont précisées ci-dessous) et frottent face à des matières comparativement molles comme le bronze ou encore les alliages d'aluminium (soit des bagues traversées par un tel axe, ou des corps de piston recevant un tel axe). Toutefois l'invention vise plus généralement le cas d'un composant mécanique, le plus souvent métallique, destiné à coopérer par glissement avec un autre composant de plus faible dureté, dans une application tribologique impliquant des conditions de charges et de vitesse connues pour être susceptibles d'induire une usure notable.

### ETAT DE LA TECHNIQUE ET PROBLEME TECHNIQUE

Le traitement d'axes de piston, notamment par un revêtement de carbone amorphe, est connu de l'homme de l'art. L'intérêt d'appliquer ce genre de revêtement est de prévenir le grippage de l'axe de piston face aux composants antagonistes souvent réalisés en bronze ou aluminium.

A ce propos, on peut se référer au document DE - 10 2011 102 209, au document WO - 2009/144076, ou encore au document « The effect of various surface treatments on piston pin scuffing résistance » de I. Etsion, G. Halperin et E. Becher, paru dans Wear 261 (2006) pp785-791 ; ce document peut se trouver à l'adresse suivante :
[http://www.technion.ac.il/∼merei02/public/2_The%20effect%20of%20vari ous%20surface%20treatments%20on%20piston%20pin.pdf]

Le document EP 1 479 946 décrit aussi une pièce mécanique et sa pièce antagoniste, comprenant un revêtement en carbone amorphe avec peu d'hydrogène. La couche de DLC est déposée sur une sous couche de CrN par PVD par arc et présente une surface avec des pics maximum de 0.03 µm (Ry) et une rugosité de surface (Ra) inférieure à 0.01 µm. D'autre part le document EP 2 647 738 décrit un piston et sa pièce antagoniste, comprenant un revêtement en carbone amorphe avec une concentration d'hydrogène, de 4.5 à 30 at% avec une rugosité de surface (rms) de 5 nm à 25 nm mesurée par AFM.

L'application d'un tel revêtement anti-grippage est devenue nécessaire à cause de l'augmentation croissante de la pression de contact existant entre ces composants. L'augmentation de pression de contact résulte de la tendance continue à diminuer les dimensions des pièces en vue d'en réduire la masse et l'énergie perdue à cause de l'inertie.

Il est généralement considéré par l'homme de métier que, au sein d'un couple de deux composants coopérant l'un avec l'autre par glissement/frottement, l'usure du composant ayant la dureté la moindre diminue avec la rugosité de surface du composant ayant la plus grande dureté. Dans le cas d'un axe de piston, il est donc habituellement considéré que l'usure d'un composant en bronze ou en aluminium diminue avec la rugosité d'un composant antagoniste revêtu d'une couche de carbone amorphe ; c'est pourquoi, afin de limiter l'usure du bronze ou de l'aluminium, un soin particulier est apporté aux axes de piston, par le biais de leur état de surface avant dépôt. Néanmoins, la minimisation de la rugosité avant dépôt ne suffit pas et doit souvent être complétée par une opération finale de traitement visant à réduire la rugosité de la pièce revêtue ; une telle opération finale peut consister en un brossage (selon des modalités connues de l'homme de métier).

Toutefois, il a été constaté que, dans certaines conditions, ni le bronze, ni l'aluminium ne s'usent, tandis que l'usure du revêtement en carbone amorphe devient anormalement importante, malgré la dureté importante d'un tel revêtement de carbone amorphe. Ainsi, deux revêtements ayant des caractéristiques mécaniques et de rugosité (au sens macroscopique du terme, voir ci-dessous) identiques peuvent se comporter de façon tout à fait différente. Dans un cas, on peut noter une usure forte de la pièce antagoniste (de dureté bien moindre, ou matériau « mou »), et une usure infime du revêtement, tandis que dans un autre cas, le matériau mou se caractérise par une usure minime en combinaison avec une usure forte du revêtement, sans qu'on en connaisse la raison.

On comprend aisément que, pour un bon fonctionnement du système, chacune des deux pièces antagonistes doit présenter une usure minimale afin d'assurer la longévité des composants.

Le besoin existe en conséquence de pouvoir fabriquer et caractériser une pièce munie d'un revêtement en carbone amorphe (à au moins 70% at. de carbone, voire au moins 90% at., hors hydrogène) de manière à garantir que, en combinaison avec une pièce antagoniste de dureté sensiblement moindre (par exemple moins de 2/3 de la dureté du revêtement), aucune des deux pièces ne présente une usure importante en service.

### SOLUTION DU PROBLEME TECHNIQUE

Pour permettre un contrôle de l'usure d'une pièce revêtue d'une couche mince dure de carbone amorphe, composée essentiellement de carbone (à plus de 70% atomique, en excluant la teneur en hydrogène), qui est destinée à frotter contre un matériau plus mou, c'est à dire dont la dureté est plus de 1,5 fois plus petite que celle du revêtement, l'invention enseigne des conditions sur les rugosités à l'échelle macroscopique (mesure conventionnelle) et à l'échelle microscopique (par microscopie à force atomique, en pratique sur une surface inférieure à 100 µm²).

Plus précisément, l'invention propose une pièce munie d'un revêtement en carbone amorphe (au moins 70% at. de carbone) et destinée à coopérer en glissement avec une pièce antagoniste dont la dureté en surface est d'au plus les deux tiers de celle du revêtement, ce revêtement ayant une rugosité Ra qui, mesurée par profilométrie, est supérieure à 0,025 microns et au plus égale à 0,050 microns et, mesurée en microscopie à force atomique, une micro-rugosité qui est au moins égale à 0,004 microns et au plus égale à 0,009 microns.

Il faut ici comprendre que la rugosité Ra est la rugosité de la pièce portant ce revêtement.

Il est en effet apparu que le respect de ces plages de rugosité, mesurées selon deux techniques différentes, conduisait à une usure modérée d'une telle pièce revêtue, sans induire d'usure importante de la pièce antagoniste bien moins dure, indépendamment des caractéristiques particulières de l'éventuel lubrifiant interposé entre les surfaces en frottement.

Pour distinguer ces deux notions de rugosité (en moyenne arithmétique), on réserve dans la suite le mot « rugosité » à ce qui est mesuré par un moyen conventionnel) et on utilise l'expression de « micro-rugosité » pour la rugosité mesurée en microscopie à force atomique.

Le moyen de mesure de rugosité conventionnel, est limité en résolution, de par la taille de la pointe (elle a typiquement un rayon local de 2 microns) ; la pointe mise en œuvre en microscopie à force atomique AFM est de plusieurs ordres de grandeur plus petite (elle a typiquement un rayon local de 0,01 micron voire inférieur) ; la pointe AFM permet donc de voir des détails plus petits que ceux que peut détecter un moyen conventionnel.

Le principe de fixer des valeurs maximale et minimale à la rugosité d'une pièce revêtue d'un film de DLC (carbone diamant) a déjà été proposé, dans le document WO - 2012/073717 ; il y est préconisé un revêtement de DLC contenant de 4,5%at à 30% at. d'hydrogène, et une rugosité quadratique moyenne comprise entre 5 nm et 25 nm (soit 0,005 et 0,025 microns) ; toutefois l'existence d'un seuil minimum n'est nullement associée à un souci de minimiser les usures de la couche de DLC et d'une pièce antagoniste, mais est proposée pour garantir un niveau de frottement suffisant pour générer l'énergie nécessaire aux réactions permettant l'action des additifs prévus au sein du lubrifiant particulier utilisé (le lubrifiant contient un composé à base de molybdène et des additions de zinc et de soufre, et la description faite dans le document tend à garantir la formation de MoS2) ; en fait ce document recommande que les deux pièces soient en des matériaux comparables, donc entre lesquels il n'y a pas de différence importante de dureté et entre lesquels ne peut se présenter le problème technique à la base de la présente invention. En tout état de cause, ce document ne divulgue pas l'intérêt de mesurer la rugosité par la technique de la microscopie à force atomique, ni a fortiori l'intérêt de fixer des seuils pour, d'une part la rugosité mesurée d'une manière conventionnelle (par profilométrie) et, d'autre part par cette technique bien particulière. Si l'on s'en tient à la seule rugosité par mesure conventionnelle (en rugosité quadratique et non Ra, en moyenne arithmétique), il est à noter que ce document enseigne une valeur maximale bien inférieure à la valeur maximale de la présente invention (en moyenne arithmétique Ra), qui serait très vraisemblablement incompatible avec la plage de micro-rugosité en AFM de l'invention. En d'autres termes, l'invention enseigne implicitement une plage de rugosité, en mesure conventionnelle, qui est supérieure à celle de ce document.

Selon l'invention, cette valeur de rugosité Ra mesurée par profilométrie est supérieure à un seuil de 0,020 microns, voire 0,025 microns. Il faut noter ici qu'il s'agit de la rugosité du revêtement, qui peut être différente de celle de la surface avant revêtement.

De manière préférée, la rugosité mesurée par profilométrie est au plus égale à 0,046 micron et la micro-rugosité en microscopie à force atomique est comprise entre 0,004 et 0,0075 microns ; de telles plages restreintes semblent être encore mieux capables de garantir un faible niveau pour les usures des deux pièces antagonistes ; il est toutefois à noter que l'invention ne vise pas à identifier une condition nécessaire et suffisante pour que les usures des deux pièces soient modérées ; elle vise simplement à fournir une condition suffisante pour obtenir un tel résultat.

Selon des caractéristiques préférées de l'invention, éventuellement combinées :
- Le revêtement contient de l'hydrogène à une teneur de 20+/-5% at., mesurée selon la technique dite ERDA,
- La pièce comporte sous le revêtement de carbone amorphe, qui est hydrogéné, une couche d'au plus un micron de CrN,
- Le revêtement comporte un dopage au tungstène sur au plus un micron à partir de la surface de la pièce, pour un film d'au moins deux microns.

L'invention propose en outre un couple de pièces coopérant par frottement, comportant une pièce du type précité et une pièce antagoniste dont la dureté en surface est d'au plus les deux tiers de celle du revêtement.

A titre d'exemples, cette pièce antagoniste peut être réalisée en un alliage cuivreux, tel que du bronze ; en variante, elle peut être réalisée en un alliage d'aluminium, par exemple en AISn. On peut aussi dire qu'il s'agit d'alliages d'étain. Une telle pièce antagoniste peut n'être formée d'un tel matériau qu'en surface.

Des objets, caractéristiques et avantages de l'invention ressortent de la description qui suit, donnée à titre d'exemple illustratif non limitatif en regard du dessin annexé sur lequel :
- La figure 1 est un diagramme corrélant la rugosité de divers exemples de pièces revêtues à l'usure de cette pièce et à celle d'une pièce antagoniste en bronze, et
- La figure 2 est un diagramme corrélant la micro-rugosité de divers exemples de pièces revêtues à l'usure de cette pièce et à celle d'une pièce antagoniste en bronze

### EXPOSE DETAILLE D'AU MOINS UN MODE DE REALISATION

Dans la suite on considère des pièces métalliques, en pratique en acier, revêtues d'un film de carbone amorphe, destiné à coopérer avec une pièce antagoniste en bronze (voire en aluminium), dans des conditions simulant les conditions de service d'un arbre (ou axe) de piston au sein d'un moteur ; il peut s'agir de l'articulation de l'arbre sur le vilebrequin ou de l'articulation de l'arbre sur le piston lui-même.

Des exemples avec un revêtement de CrN servent d'éléments de comparaison.

La mesure de rugosité Ra classique permet de définir le niveau nécessaire requis, d'après l'approche habituelle, afin de limiter l'usure de la pièce (bronze ou aluminium, notamment) antagoniste de l'axe revêtu de la couche dure. Néanmoins, pour un revêtement donné, les caractérisations classiques de la pièce revêtue ne permettent pas de déterminer si le revêtement va ou non subir de l'usure. Pour de mêmes valeurs de rugosité Ra (mesurée de manière conventionnelle) et de dureté, deux revêtements apparemment similaires peuvent, l'un ne subir aucune usure et l'autre, au contraire, subir une usure excessive, sans qu'on en ait encore compris la raison (ce ne peut pas être simplement de l'abrasion à cause du niveau important du rapport entre les duretés des pièces antagonistes). Selon un aspect de l'invention, l'examen de surface des pièces par la technologie de microscopie à force atomique (ou AFM) contribue à permettre de déterminer la topographie idéale que la pièce revêtue doit avoir pour minimiser l'usure des deux pièces antagonistes.

Dans les exemples qui suivent, des axes de piston, initialement identiques (aux tolérances de fabrication près) ont été revêtus respectivement de dépôts de nitrure de chrome CrN et de divers types de matériaux à base de carbone amorphe ; actuellement on utilise assez souvent le sigle DLC en tant que synonyme de toutes les formes de carbone amorphe ; en fait, le sigle DLC (« Diamant-Like Carbon ») désigne du carbone ayant des atomes de carbone présentant une hybridation telle que dans du diamant et devrait être réservé à cette forme de carbone amorphe. Dans la suite, les dénominations abrégées reprendront le sigle DLC pour les diverses formes de carbone amorphe, pour des raisons de simplicité, qu'il s'agisse de carbone amorphe hydrogéné, de carbone amorphe non hydrogéné (pour lequel le sigle DLC paraît tout à fait exact), ou de carbone amorphe hydrogéné dopé au tungstène

Les axes de piston ont été caractérisés, avant dépôt, par une mesure de rugosité Ra de 0,025 µm et une mesure de rugosité Rpk de 0,040 µm. Des mesures en rugosité Rpk sont ici données en complément des mesures de rugosité, pour compléter la caractérisation des exemples. Comme indiqué ci-dessus, les revêtements qui vont être déposés peuvent avoir des rugosités bien différentes, en fonction notamment des modalités de formation de ces revêtements.

Dans la suite, les mesures de dureté Hv correspondent à une charge de 10 à 30 mN, adaptée à l'épaisseur du revêtement et à sa dureté, de sorte que la profondeur d'indentation est de l'ordre d'un dixième de l'épaisseur du dépôt ; ainsi la mesure de dureté n'intègre pas de façon significative la dureté du substrat.

Les couches de CrN ont été élaborées par pulvérisation magnétron, étant précisé que ce genre de dépôt donne habituellement des couches sous-stœchiométriques. La teneur en azote s'est située à 40+/-5 % atomique. Ces dépôts de CrN se caractérisent en pratique par une dureté Vickers de 1800+/- 200 Hv. Deux épaisseurs de dépôt ont été envisagées, 1 µm et 2 µm, d'où des désignations CrN1 et CrN2, respectivement.

Les dépôts de carbone amorphe hydrogénés sont classiquement réalisés par dépôt chimique en phase vapeur (Chemical Vapor Déposition, ou CVD) sous argon ; de préférence la technique de dépôt est une forme particulière de CVD, à savoir un dépôt CVD assisté par un plasma - en anglais « Plasma assisted CVD » ou « PACVD » ou « Plasma Enhanced CVD » ou « PECVD ») Ces couches se sont caractérisées par une dureté de 3000+/- 400Hv, ce qui correspond à une teneur en hydrogène mesurée en ERDA de 20+/-5 at. %. Ces couches ont été déposées à une épaisseur de 2 microns sur une sous-couche de CrN ayant deux épaisseurs possibles :
- Un double dépôt de 0,8 µm de CrN puis de 2,0 µm de carbone amorphe hydrogéné est appelé ici DLC1,
- Un double dépôt de 1,5 µm de CrN puis de 2,0 µm de carbone amorphe hydrogéné est appelé ici DLC2.

A titre de variante de la référence DLC1, un autre dépôt de carbone amorphe hydrogéné a été formé en faisant varier les conditions de dépôt de CrN, notamment en augmentant la pression totale d'argon ; ce dépôt est désigné dans la suite par DLC3.

Le revêtement de carbone amorphe non hydrogéné est élaboré par une technologie de dépôt d'évaporation par arc cathodique. Sa dureté a été mesurée à 4500 Hv. Il a été considéré à une épaisseur unique, à savoir une épaisseur d'un micron ; le revêtement ainsi obtenu est désigné par DLC4 dans la suite. Le dépôt de carbone amorphe non hydrogéné, DLC (ou taC) est formé par une technique PVD (l'évaporation par arc cathodique de graphite).

Enfin, le dépôt de carbone amorphe hydrogéné dopé au tungstène a été élaboré par pulvérisation cathodique magnétron à partir d'une cible de carbure de tungstène, dans une atmosphère contenant une pression partielle d'hydrocarbure. Ce dépôt s'est caractérisé par une dureté de 1400Hv et une teneur de W de 10% atomique (hors hydrogène). Il peut s'analyser comme étant formé d'une sous-couche de WC recouverte de carbone (avec une élévation progressive de la teneur en carbone jusqu'à devenir 90% ; le revêtement ici considéré a comporté une couche de WC de 0,6 µm d'épaisseur (qui s'enrichit progressivement en carbone) pour une épaisseur totale de 2,5 µm ; ce revêtement est appelé DLC5 dans la suite.

Il importe de rappeler (voir ci-dessus) que les duretés mentionnées ci-dessus sont bien des duretés des revêtements, malgré leurs faibles épaisseurs, et non des duretés des matériaux sous-jacents.

Les revêtements de carbone amorphe sont notablement plus durs que ceux de CrN, surtout lorsqu'ils ne sont pas hydrogénés (généralement formés à 100% de carbone - cas du DLC), à l'exception du revêtement du carbone amorphe hydrogéné dopé au tungstène ; en conséquence, les revêtements de carbone amorphe (hydrogénés ou non hydrogénés, non dopés au tungstène) ont habituellement une résistance à l'usure, notamment par abrasion, plus élevée que les revêtements en CrN.

Enfin ces revêtements ont subi, ou non, une étape finale de brossage plus ou moins intense selon des modalités connues en soi.

Le brossage a été caractérisé par deux grandeurs principales, la pression d'appui de la brosse et le nombre de passages sous la brosse, ainsi que cela ressort du tableau suivant.

| Type de brossage | pression | Nombre de passages |
|---|---|---|
| + | 0,4 bars | 1 |
| ++ | 1,5 bars | 1 |
| ++++ | 1,5 bars | 4 |

Un tel brossage permet de faire disparaître des excroissances pouvant s'être formées lors de l'opération de dépôt des couches et qui constituent des pics susceptibles d'aggraver l'usure de la pièce antagoniste, à la manière d'une râpe. Ces excroissances ont une tenue mécanique très faible, ce qui fait qu'elles sont éliminées à l'issue du brossage le plus léger. Les brossages plus intenses ont pour conséquence de polir la surface du dépôt.

L'ensemble de ces pièces a subi des caractérisations de rugosité par profilométrie, mais aussi des mesures de micro-rugosité en utilisant la technique dite de microscopie à force atomique « AFM » en effectuant des images de 5×5 µm. En d'autres termes, les diverses pièces ont fait l'objet d'une mesure macroscopique (conventionnelle) de rugosité au moyen d'un rugosimètre (à l'échelle du dixième de micron) et une mesure nanométrique par AFM (à l'échelle de la dizaine de nanomètres) ; comme indiqué ci-dessus, cette rugosité est appelée « micro-rugosité » pour l'identifier par rapport à la rugosité macroscopique.

Toutes ces pièces ont enfin été caractérisées sur le plan tribologique, visant à quantifier l'usure de la pièce revêtue, mais aussi l'usure de la pièce antagoniste réalisée dans un métal ici qualifié de mou (c'est-à-dire dont la dureté est d'au plus deux tiers de celle du revêtement considéré).

Dans les exemples qui suivent le métal mou est un cylindre de bronze de 10 mm de diamètre dont le Ra de 0,3 µm est représentatif d'une pièce réelle. Les essais de frottement ont été réalisés dans une configuration de type axes croisés : le mouvement relatif a été produit dans le sens parallèle aux stries sur l'axe de piston et le point de contact a été déplacé sur une génératrice de l'axe en bronze sur une course de 10 mm. La charge appliquée a été de 11,6 N. La vitesse moyenne de glissement a été de 100 mm/s selon un mouvement alternatif donné par un système excentrique. Avant essai, le contact a été mouillé par une goutte d'huile SAE5W30. Le système a été chauffé à 110 °C.

A l'issue des 9000 cycles de test, l'usure a été caractérisée par la mesure des dimensions de la zone de frottement. Pour l'axe en bronze, la mesure a été faite selon la largeur de la trace de frottement. Pour la pièce revêtue, la mesure d'usure a été faite dans la direction de frottement. On a noté que la largeur initiale de contact sur le bronze a été de 320 µm ; par conséquent, des dimensions de traces de frottement, sur le bronze, de l'ordre de 320 µm jusqu'à 340 µm, dénotent une usure du bronze faible ou nulle. De même, la dimension de l'aire initiale de contact sur l'axe revêtu, dans la direction de frottement, a été de 240 µm ; des dimensions allant jusqu'à 260 µm indiquent donc des usures faibles du revêtement. Il faut noter que, puisque les revêtements sont sensiblement plus durs que les pièces antagonistes, leur usure ne peut pas correspondre à de l'abrasion.

Le tableau suivant corrèle diverses caractéristiques des revêtements. Des mesures d'usure peuvent correspondre à des valeurs inférieures aux mesures initiales mentionnées ci-dessous, notamment en raison des incertitudes de mesures (en fait, les éprouvettes sont des cylindres dont la rugosité et la géométrie ne sont pas aussi idéales que les caractéristiques utilisées pour le calcul des dimensions du contact ; la géométrie réelle et la topographie réelle peuvent avoir pour effet que l'aire initiale, qui correspond théoriquement à une ellipse, peut être légèrement inférieure à 240 µm.

| Essai | dépôt | finition | Rugosimètre | | AFM | Usure dépôt | Usure bronze | conformité |
|---|---|---|---|---|---|---|---|---|
| | | | Ra(conv) | RPk | µRa | | | |
| 1 | DLC 2 | non | 0,053 | 0,080 | 0,0103 | 239 | 398 | non |
| 2 | DLC 2 | ++++ | 0,045 | 0,066 | 0,0098 | 238 | 380 | non |
| 3 | DLC1 | non | 0,046 | 0,045 | 0,0068 | 260 | 322 | oui |
| 4 | DLC1 | + | 0,043 | 0,040 | 0,0065 | 244 | 315 | oui |
| 5 | DLC1 | ++ | 0,041 | 0,037 | 0,0034 | 304 | 320 | non |
| 6 | DLC1 | ++++ | 0,045 | 0,042 | 0,0032 | 301 | 330 | non |
| 7 | DLC3 | non | 0,050 | 0,070 | 0,0121 | 232 | 400 | non |
| 8 | DLC3 | ++++ | 0,049 | 0,064 | 0,0112 | 236 | 395 | non |
| 9 | DLC4 | non | 0,054 | 0,095 | 0,0980 | 232 | 440 | non |
| 10 | DLC4 | ++++ | 0,043 | 0,046 | 0,0033 | 312 | 317 | non |
| 11 | DLC5 | non | 0,050 | 0,075 | 0,0070 | 250 | 345 | limite |
| 12 | DLC5 | ++ | 0,042 | 0,040 | 0,0034 | 325 | 315 | non |
| 13 | CrN 1 | + | 0,046 | 0,042 | 0,0070 | 250 | 350 | non |
| 14 | CrN 2 | + | 0,052 | 0,079 | 0,0135 | 234 | 435 | non |
| 15 | CrN 1 | ++++ | 0,045 | 0,038 | 0,0033 | 235 | 318 | non |

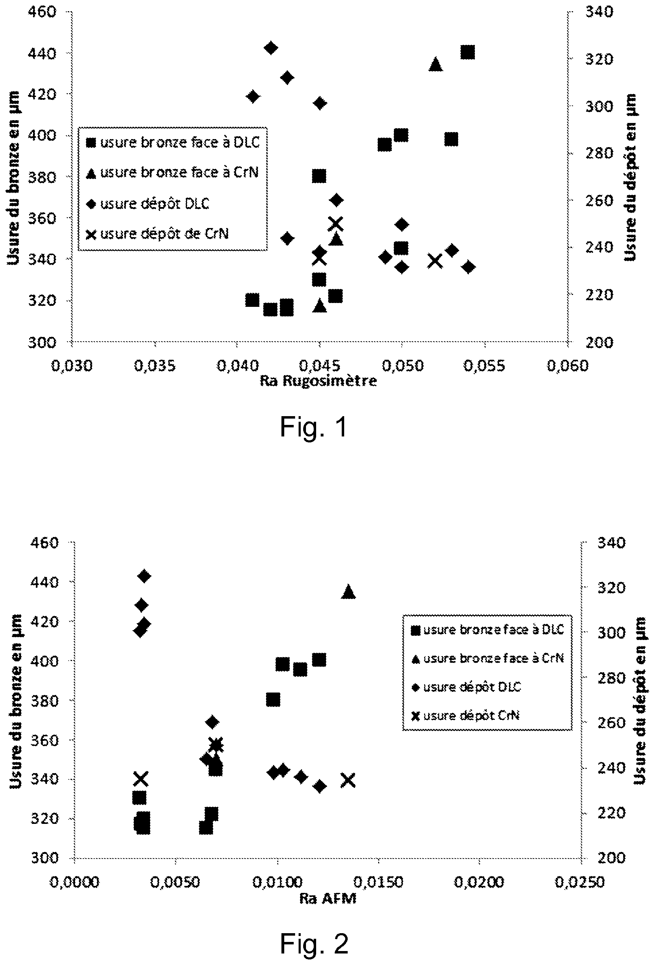

Ces résultats sont en outre visualisés sur le graphique de la figure 1 (mesures de rugosité Ra au moyen d'un rugosimètre ayant un palpeur de 2 µm de rayon) et sur le graphique de la figure 2 (micro-rugosité en AFM, notée µRa en abrégé) :
- Les carrés représentent les usures en microns d'une pièce en bronze face à un revêtement DLC (échelle de gauche),
- Les losanges représentent les usures des revêtements DLC (échelle de droite),
- Les triangles représentent les usures d'une pièce en bronze face à un revêtement CrN (échelle de gauche), et
- Les croix représentent les usures des revêtements CrN (échelle de droite.

On peut supposer que les deux échelles de mesure de rugosité ne donnent pas exactement la même information : la rugosité macroscopique résulte en grande partie de l'usinage de la pièce avant le dépôt du revêtement, tandis que la micro-rugosité caractérise principalement la croissance du revêtement, avec une incidence moindre de l'usinage précité.

Dans le diagramme de la figure 1, on retrouve un résultat connu de l'état de l'art, à savoir que l'usure du bronze est en relation avec la rugosité de la pièce antagoniste, lorsqu'elle est mesurée de façon conventionnelle. La diminution de rugosité de la pièce revêtue induit de façon naturelle la diminution de l'usure de l'antagoniste qui est plus mou.

Ce diagramme de la figure 1 montre par contre, contrairement à ce qu'on pouvait supposer, que les revêtements DLC peuvent subir une usure importante, bien que leur nature ne les prédispose pas à s'user (ils sont plus durs que les pièces en bronze). En outre, l'usure des revêtements n'est pas en relation avec leur rugosité. En effet, en ce qui concerne les revêtements en CrN, on observe une usure qui semble ne pas dépendre de la rugosité du revêtement, tandis que, en ce qui concerne les revêtements en DLC, on croit même pouvoir lire une corrélation négative, c'est-à-dire que l'usure est d'autant plus importante que la rugosité est faible.

Des commentaires similaires peuvent être faits à propos du diagramme de la figure 2, étant précisé que l'usure des pièces en bronze est presque proportionnelle à la rugosité AFM (la moyenne intercepte la ligne des abscisses pour une valeur très faible de la rugosité AFM). Quant à l'usure des pièces revêtues en carbone amorphe, elle semble rester raisonnable tant que cette rugosité AFM dépasse de l'ordre de 0.0050 microns (en ce qui concerne les revêtements en CrN, l'usure reste faible dans tous les cas).

En d'autres termes, ces mesures de rugosité et micro-rugosité mettent en évidence qu'il existe une relation inversement proportionnelle entre la rugosité et la micro-rugosité de la pièce revêtue et son usure face à une pièce antagoniste pourtant bien moins dure (ou plus molle), puisqu'il apparaît que ce sont les couches de carbone amorphe les plus lisses qui présentent les usures les plus importantes.

Plus précisément, parmi les couches de carbone amorphe hydrogéné (DLC1 à DLC3) :
- Les usures des pièces antagonistes en bronze baissent à peine lorsque les revêtements sont brossés (on peut même noter que, aux incertitudes de mesure près, il n'y a pas de différence sensible entre les exemples 3 et 6),
- L'usure de ces pièces antagonistes en bronze ne diminue pas (voire augmente) au fur et à mesure que le brossage est amélioré (voir les DLC1),
- La rugosité Ra du revêtement baisse lorsque l'on effectue un brossage, mais un prolongement du brossage n'a pas nécessairement un effet favorable à cette réduction,
- Par contre, la micro-rugosité AFM du revêtement baisse lorsque l'on effectue un brossage et diminue encore au fur et à mesure que ce brossage se poursuit, la micro-rugosité minimale étant observée avec les DLC1 (avec la sous-couche de CrN la plus faible),
- Un brossage ne conduit pas à une réduction de l'usure du revêtement (DLC2, DLC3) ; si une faible réduction est constatée à propos du DLC1, un prolongement du brossage a même pour effet de favoriser l'usure,
- Sauf en ce qui concerne ces DLC1 ayant subi un brossage prolongé, l'usure du revêtement reste modérée (en dessous de 260 microns)
- L'augmentation de la couche sous-jacente en CrN n'a pas d'effet favorable sur l'usure des pièces en bronze ; au contraire, seuls les revêtements DLC1, avec une épaisseur de couche sous-jacente d'à peine 0,8 microns, présentent une usure modérée, à l'état non brossé ou peu brossé,
- L'augmentation de la pression d'argon lors du dépôt du revêtement n'a pas d'effet positif visible (comparer les DLC2 et les DLC3).

En ce qui concerne les DLC non hydrogénés (DLC4) :
- Un brossage du revêtement semble être nécessaire pour maintenir à un niveau raisonnable l'usure de la pièce antagoniste en bronze, mais au détriment de l'usure du revêtement,
- On peut penser qu'un brossage modéré est susceptible de conduire à un compromis acceptable.

Enfin en ce qui concerne les DLC au tungstène (DLC5) :
- Un brossage semble avoir un effet positif sur l'usure de la pièce antagoniste en bronze, mais cette usure reste modérée même en l'absence d'un tel brossage,
- Par contre l'effet positif du brossage pour la pièce antagoniste apparaît au détriment de l'usure du revêtement.

Il peut être noté que le fait d'effectuer un brossage est une opération prévue par les cahiers des charges des fabricants d'axes de piston en vue de supprimer les défauts de croissance du revêtement ; toutefois, compte tenu de leur très faible densité (sauf pour les dépôts de carbone amorphe non hydrogénés, qui selon les particularités de la technique d'élaboration, peuvent présenter de très grandes quantités de défauts de croissance), il semble douteux que ces défauts puissent avoir une influence significative sur les phénomènes d'usure indiqués ci-dessus.

On peut noter que les exemples 1 et 7 à 9 sont des cas conformes à une situation connue de l'homme de l'art, à savoir qu'une usure importante des pièces antagonistes en bronze est constatée avec les éprouvettes revêtues les plus rugueuses (plus de 0,050+/-0,001 microns en rugosité Ra), même s'il n'y a pas de réelle proportionnalité entre les rugosités et les usures (l'exemple 1 est plus rugueux que l'exemple 7 tout en conduisant à une moindre usure ; la rugosité n'est en effet pas le seul paramètre à intervenir). Il est à noter que les micro-rugosités AFM constatées sur ces exemples font partie des valeurs les plus élevées constatées (supérieures à 0,0090).

Quant aux exemples 5, 6, 10 et 12, on peut noter qu'ils correspondent à des valeurs importantes d'usure des revêtements. Ce résultat apparaît comme surprenant pour l'homme de l'art car les revêtements sur ces pièces ne se distinguent pas en termes de caractéristiques mécaniques ou chimique de leurs couches homologues plus rugueuses. Bien que les revêtements soient beaucoup plus durs que l'antagoniste en bronze (sensiblement plus mou), une usure forte se manifeste. L'examen de la rugosité par technique AFM révèle qu'à l'échelle de quelques µm², ces couches se distinguent des autres couches par un Ra particulièrement bas (inférieur à 0,004 µm).

On peut noter que l'exemple 11 correspond à une usure de la pièce en bronze à peine supérieure au seuil indiqué et peut être considéré comme étant limite.

Cela conduit à considérer que, lorsqu'un revêtement de carbone amorphe (au moins 70% at. de carbone) a une rugosité Ra au plus égale à 0,050 microns, en combinaison avec une micro-rugosité Ra en AFM supérieure à 0.004 microns mais inférieure à 0,009 microns, on combine de faibles usures du revêtement et de la pièce antagoniste en bronze (bien qu'elle soit sensiblement moins dure que le revêtement).

En effet seuls les exemples satisfaisant à la double condition précitée conduisent à des usures faibles des deux pièces en frottement réciproque.

Il semble que les usures sont d'autant plus faibles que la rugosité du revêtement :
- Est au plus égale à 0,046 microns en mesure conventionnelle
- Et est comprise entre 0,004 et 0,0075 microns en AFM.

Il mérite d'être souligné que les bons exemples ainsi identifiés correspondent à des revêtements non brossés ou à peine brossés, avec un carbone amorphe hydrogéné (de préférence avec une teneur en hydrogène ayant une faible couche sous-jacente de CrN (apparemment pas plus d'un micron) ou un carbone amorphe hydrogéné dopé au tungstène (apparemment pas plus, non plus, d'un micron). S'agissant des carbones amorphes non hydrogénés, il semble qu'un brossage modéré puisse conduire au respect des conditions précitées et donc à des usures réciproques modérées.

Par ailleurs il ressort de ce qui précède que la nature du revêtement est déterminante puisque les exemples 1 à 12, comportant une couche dure à base de carbone amorphe (plus de 70% atomique hors hydrogène), conduisent à des conclusions différentes des exemples 13 à 15, obtenus avec un revêtement de CrN. Notamment, comme pour les couches en carbone amorphe, les dépôts de CrN conduisent à une usure accrue du bronze quand la rugosité de la pièce revêtue augmente, tandis qu'à basse ou très basse rugosité les couches de CrN ne s'usent pas et n'usent pas l'antagoniste de bronze. Ces résultats montrent que le phénomène d'usure des revêtements carbone amorphe n'est pas mécanique ni abrasif, car ces couches sont plus dures que du CrN ou nettement plus de 1,5 fois plus dures que l'antagoniste. Ainsi la forte usure des couches de carbone amorphe aux très basses rugosités n'est pas un phénomène commun et connu de l'homme de l'art. Comme les revêtements en question sont majoritairement composés de carbone, on peut imaginer, sans vouloir être tenu par une telle interprétation, qu'intervient un mécanisme pouvant être du type tribo-oxydation, et donc insensible à la dureté des couches de carbone.

Uniquement d'un point de vue résistance à l'usure, une couche très lisse de CrN remplit la fonction attendue. Par contre, avec le souci constant d'abaissement de frottement, les revêtements en carbone amorphe sont préférés au CrN parce qu'ils permettent des coefficients de frottement plus bas. Les plages de rugosité identifiées ci-dessus permettent de garantir des niveaux d'usure raisonnables.

Il peut être noté que, dans le tableau ci-dessus, une colonne est située entre les colonnes Ra et µRa (AFM), dont l'intitulé est RPk ; cette colonne recense la rugosité obtenue selon une variante de mesure de rugosité. On peut noter que cette autre manière de caractériser la rugosité permet des conclusions analogues.

Les conclusions ci-dessus se généralisent à d'autres couples de matériaux ; ainsi, plus généralement, la pièce antagoniste (ayant la faible dureté définie ci-dessus) peut être en un quelconque alliage cuivreux, ou en un quelconque alliage d'aluminium ; ce peut être notamment le cas pour des axes de piston. Il peut s'agir d'un alliage d'étain tel que AlSn (notamment utilisé sur certains coussinets de vilebrequin ou au niveau de la tête d'une bielle). On comprend que cette pièce antagoniste peut n'être en un matériau mou qu'en surface (et comporter une âme en un autre matériau).

Il mérite d'être souligné qu'il est à la portée de l'homme de métier, connaissant la rugosité et la microrugosité à obtenir, d'ajuster les conditions de dépôt. En effet, un ensemble de paramètres opératoires sont à la disposition de l'homme de métier pour faire varier la morphologie des dépôts et même des sous-couches PVD ; les couches PVD croissent en général avec une structure de colonnes dont la taille augmente avec l'épaisseur, ce qui influe sur la rugosité.

## Revendications

1. Pièce mécanique munie d'un revêtement en carbone amorphe avec au moins 70% at. de carbone hors hydrogène et destinée à coopérer en glissement avec une pièce antagoniste dont la dureté en surface est d'au plus les deux tiers de celle du revêtement, ce revêtement ayant une rugosité Ra qui, mesurée par profilométrie, est supérieure à 0,025 microns et au plus égale à 0,050 microns et, mesurée en microscopie à force atomique, une micro-rugosité qui est au moins égale à 0,004 microns et au plus 0,009 microns.

2. Pièce selon la revendication 1, dont la rugosité, mesurée par profilométrie, est au plus égale à 0,046 microns et la micro-rugosité en microscopie à force atomique est comprise entre 0,004 et 0,0075 microns.

3. Pièce selon l'une quelconque des revendications 1 ou 2 dont le revêtement contient de l'hydrogène à une teneur de 20+/-5% at., mesurée selon la technique dite ERDA.

4. Pièce selon l'une quelconque des revendications 1 à 3, comportant sous le revêtement de carbone amorphe, qui est hydrogéné, une couche d'au plus un micron de CrN.

5. Pièce selon l'une quelconque des revendications 1 à 3, comportant un dopage en tungstène sur au plus un micron à partir de la surface de la pièce, pour un film d'au moins deux microns.

6. Couple de pièces coopérant par frottement comportant une pièce selon l'une quelconque des revendications 1 à 5 et une pièce antagoniste dont la dureté de surface est d'au plus les deux tiers de celle du revêtement.

7. Couple de pièces selon la revendication 6, dans lequel la pièce antagoniste est en un alliage cuivreux.

8. Couple de pièces selon la revendication 6, dans lequel la pièce antagoniste est un alliage d'aluminium.

9. Couple de pièces selon la revendication 6, dans lequel la pièce antagoniste est en un alliage d'étain.

## Patentansprüche

1. Mechanisches Teil, das mit einer Beschichtung aus amorphem Kohlenstoff mit mindestens 70 At.-% Kohlenstoff ohne Wasserstoff versehen und zum gleitenden Zusammenwirken mit einem Antagonistenteil bestimmt ist, dessen Oberflächenhärte höchstens zwei Drittel derjenigen der Beschichtung beträgt, wobei die Beschichtung eine Rauheit Ra aufweist, die, gemessen durch Profilometrie, mehr als 0,025 Mikrometer und höchstens gleich 0,050 Mikrometer beträgt, und, gemessen durch Rasterkraftmikroskopie, eine Mikrorauheit aufweist, die mindestens gleich 0,004 Mikrometer und höchstens 0,009 Mikrometer beträgt.

2. Teil nach Anspruch 1, dessen Rauheit, gemessen durch Profilometrie, höchstens gleich 0,046 Mikrometer beträgt und dessen Mikrorauheit in der Rasterkraftmikroskopie zwischen 0,004 und 0,0075 Mikrometer liegt.

3. Teil nach einem der Ansprüche 1 bis 2, dessen Beschichtung Wasserstoff in einem Gehalt von 20 +/-5 At.-%, gemessen mit der sogenannten ERDA-Technik, umfasst.

4. Teil nach einem der Ansprüche 1 bis 3, das unter der Beschichtung aus amorphem Kohlenstoff, der hydriert ist, eine Schicht von höchstens einem Mikrometer CrN umfasst.

5. Teil nach einem der Ansprüche 1 bis 3, das eine Wolframdotierung über höchstens einem Mikrometer von der Oberfläche des Werkstücks für einen Film von mindestens zwei Mikrometern umfasst.

6. Teilepaar, das über Reibung zusammenwirkt, umfassend ein Teil nach einem der Ansprüche 1 bis 5 und ein Antagonistenteil, dessen Oberflächenhärte höchstens zwei Drittel derjenigen der Beschichtung beträgt.

7. Teilepaar nach Anspruch 6, bei dem das Antagonistenteil aus einer Kupferlegierung besteht.

8. Teilepaar nach Anspruch 6, bei dem das Antagonistenteil aus einer Aluminiumlegierung besteht.

9. Teilepaar nach Anspruch 6, bei dem das Antagonistenteil aus einer Zinnlegierung besteht.

## Claims

1. A mechanical part provided with a coating of amorphous carbon with at least 70% at. carbon excluding hydrogen and configured to slidingly cooperate with a counterbody part of which the surface hardness is at most two thirds of that of the coating, that coating having a roughness Ra which, measured by profilometry, is greater than 0.025 microns and at most equal to 0.050 microns and, measured with atomic-force microscopy, a micro-roughness which is at least equal to 0.004 microns and at most 0.009 microns.

2. A part according to claim 1, of which the roughness, measured by profilometry, is at most equal to 0.046 microns and the micro-roughness by atomic force microscopy is comprised between 0.004 and 0.0075 microns.

3. A part according to claim 1 or claim 2 of which the coating contains hydrogen in an amount of 20+/-5% at., measured according to the ERDA technique.

4. A part according to any one of claims 1 to 3, comprising under the coating of amorphous carbon, which is hydrogenated, a layer of at most one micron of CrN.

5. A part according to any one of claims 1 to 3, comprising tungsten doping over at most one micron from the surface of the part, for a film of at least two microns.

6. An pair of slidingly cooperating parts comprising a part according to any one of claims 1 to 5 and a counterbody part of which the surface hardness is at most two thirds of that of the coating.

7. A pair of parts according to claim 6, wherein the counterbody part is of a copper alloy.

8. A pair of parts according to claim 6, wherein the counterbody part is an aluminum alloy.

9. A pair of parts according to claim 6, wherein the counterbody part is of a tin alloy.
